# FASCICULE DE BREVET EUROPEEN

(11) **EP 0 991 950 B1**
(45) Date de publication et mention de la délivrance du brevet: **11.09.2002**
(21) Numéro de dépôt: 98914767.3
(22) Date de dépôt: 27.04.1998
(51) Int. Cl.: G01R 15/20, H01F 27/36, G01R 1/18, G01R 19/10

(54) **CAPTEUR DE COURANT**
STROMSENSOR
CURRENT SENSOR

(30) Priorité: 04.07.1997 CH 173697
(43) Date de publication de la demande: 12.04.2000
(73) Titulaire: LIAISONS ELECTRONIQUES-MECANIQUES LEM S.A., 1228 Plan-les-Ouates (CH)
(72) Inventeur: CATTANEO, Frédéric, F-74560 Monnetier Mornex (FR); CATTANEO, Pierre, F-74160 Collonge s/Salève (FR); VUILLERMOZ, Guy, F-74100 Ville la Grand (FR)
(74) Mandataire: Reuteler, Raymond Werner
(86) Numéro de dépôt international: CH9800169
(87) Numéro de publication internationale: WO99001773

(56) Documents cités:
- EP-A- 0 738 894
- WO-A-96/30773
- DE-A- 3 512 784
- FR-A- 2 538 120
- GB-A- 2 128 047
- US-A- 4 808 929
- US-A- 5 436 557

## Description

La présente invention concerne un capteur de courant électrique pour la mesure du courant passant dans un conducteur primaire, comportant un circuit magnétique couplé avec une bobine secondaire et agencé de façon à pouvoir être couplé avec ledit conducteur primaire, et comportant en outre des moyens pour mesurer le flux magnétique dans ce circuit magnétique, des moyens d'asservissement agencés de façon à faire passer, dans la bobine secondaire, un courant de compensation tendant à annuler ledit flux magnétique, et des moyens de mesure de ce courant de compensation.

Un capteur de ce type est décrit dans EP-A-738894. De tels capteurs sont souvent utilisés dans des circuits de puissance dans lesquels le courant à mesurer est commuté à fréquence élevée. Un exemple typique est l'alimentation d'un moteur asynchrone à partir d'un pont onduleur triphasé, les capteurs étant placés sur les trois lignes reliant les phases du moteur au pont onduleur.

Les vitesses de commutation peuvent atteindre des valeurs très élevées conduisant, par exemple, à des variations de tension de l'ordre de 10 kV/µs et même supérieures.

Ces variations de tension étant appliquées aux conducteurs primaires des capteurs, les capacités de fuite entre ces conducteurs et les bobines secondaires correspondantes peuvent donner lieu à des courants parasites très importants. En effet, ces capacités de fuite sont particulièrement élevées dans les capteurs de faibles dimensions, tels qu'ils résultent de la recherche de miniaturisation dans ce domaine. D'autre part, l'isolation et l'étanchéité sont souvent assurées par l'introduction d'une résine de moulage à l'intérieur du capteur. Des capacités de fuite de l'ordre de 5 à 10 pF peuvent ainsi exister entre le conducteur primaire et la bobine secondaire, ce qui fait apparaître, lors d'une transition correspondant à une variation de tension de 10 kV/µs, des courants de fuite atteignant 50 à 100 mA. De telles valeurs conduisent à des erreurs de mesure extrêmement élevées.

Une solution déjà appliquée consiste à disposer autour du conducteur primaire un écran sous forme d'un feuillard de cuivre relié à un potentiel fixe. Cette solution présente le désavantage de ne pas fournir une protection suffisamment efficace, car un tel écran n'entoure pas complètement ni le conducteur primaire, ni la bobine secondaire, et laisse ainsi subsister des capacités de fuite résiduelles non-négligeables. D'autre part, la réalisation et surtout la mise à un potentiel fixe de cet écran n'est ni simple, ni bon-marché.

Une autre solution consiste à placer, autour de la bobine secondaire, un feuillard de cuivre isolé sur ses deux faces et bordé de manière à ne pas créer de spires en court-circuit. Cette façon de procéder est toutefois très coûteuse, notamment dans le cas d'une bobine secondaire torique et surtout si le diamètre du tore est petit.

Selon un premier aspect de l'invention, celle-ci vise à remédier à ces inconvénients et à fournir un capteur de courant dans lequel les effets des capacités de fuite entre le conducteur primaire et la bobine secondaire sont pratiquement totalement éliminés par des moyens très simples et économiques.

A cet effet, le capteur de courant selon l'invention est caractérisé en ce que la bobine secondaire comporte, à la surface d'un enroulement, parcouru par le courant de compensation, au moins une couche de spires en fil isolé formant un enroulement de protection ouvert, connecté dans son ensemble à un point de potentiel électrique fixe.

De préférence, les spires de l'enroulement de protection sont jointives.

Selon un autre aspect de l'invention, un capteur du type mentionné au début comporte, d'une part, une ouverture de passage traversant l'intérieur du circuit magnétique de façon à permettre l'insertion d'au moins un premier conducteur primaire et, d'autre part, deux ou plusieurs parties séparées de conducteur primaire entourant partiellement des sections respectives du circuit magnétique, ces parties de conducteur étant agencées de façon à pouvoir être connectées, à l'extérieur du capteur, individuellement, en série, en parallèle ou en série-parallèle à au moins un deuxième conducteur primaire.

Les parties séparées de conducteur primaire sont de préférence des parties en forme de U, dont les extrémités sont agencées de façon à permettre le montage de ces parties sur une plaque de circuit extérieure au capteur pour leur connexion électrique et/ou le support du capteur.

Un tel agencement vise notamment à fournir un capteur utilisable pour la mesure différentielle de deux courants primaires de sens opposé, passant, respectivement, dans un conducteur traversant ladite ouverture et dans au moins une desdites parties séparées de conducteur primaire.

En particulier, cet aspect de l'invention permet de réaliser une très bonne isolation entre des conducteurs primaires couplés avec le capteur, respectivement par le passage à travers ladite ouverture du capteur et par l'intermédiaire desdites parties séparées de conducteur primaire.

Les agencements décrits ci-dessus relatifs à la protection de l'enroulement secondaire et à l'isolation de conducteurs primaires séparés peuvent avantageusement être combinés dans un même capteur.

D'autres particularités, avantages et buts de la présente invention, ressortiront de la description d'une forme de réalisation donnée ci-après à titre d'exemple et illustrée dans les dessins annexés dans lesquels
la Fig. 1 montre schématiquement et partiellement, en coupe, un capteur de courant selon l'invention,
la Fig. 2 est une vue latérale de l'enroulement secondaire et du conducteur primaire de la Fig. 1,
la Fig. 3 est une vue de face d'une forme d'exécution particulière d'un capteur de courant selon l'invention, et
la Fig. 4 est une vue en coupe selon la ligne IV-IV de la Fig. 1.

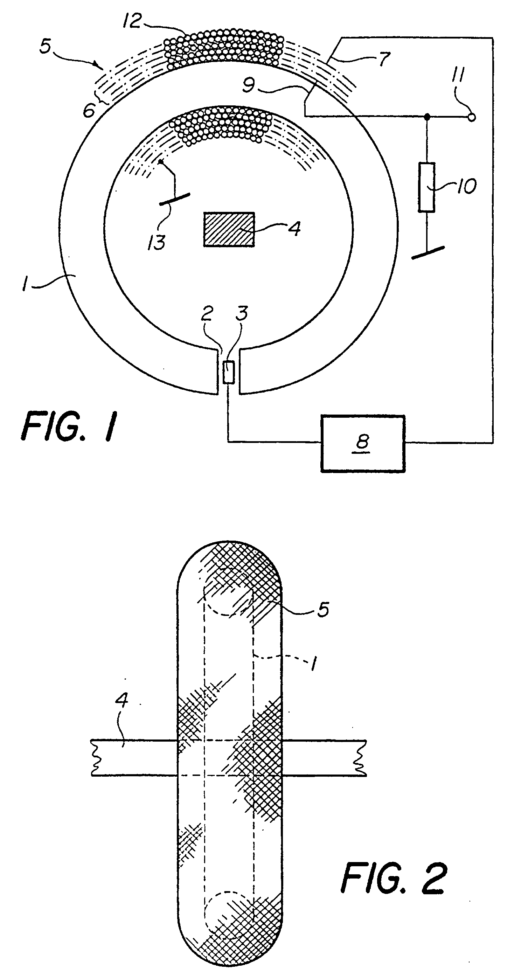

Le capteur illustré aux Figures 1 et 2 comporte un circuit magnétique fermé 1 sous forme d'un tore en un matériau ayant une bonne perméabilité magnétique, ce tore présentant un entrefer 2 dans lequel est disposé un détecteur de champ magnétique 3.

Un conducteur primaire 4 traverse le circuit magnétique 1 approximativement au centre du tore. Ce dernier porte par ailleurs une bobine secondaire 5 qui comporte plusieurs couches d'un enroulement secondaire 6. Une extrémité 7 de l'enroulement 6 est connectée à la sortie d'un circuit d'asservissement 8 dont une entrée est reliée au détecteur 3 qui lui fournit un signal de mesure du flux magnétique dans le circuit 1.

La sortie du circuit d'asservissement 8 applique à l'enroulement secondaire 6 un courant de compensation qui tend à annuler le flux magnétique engendré dans le circuit 1. Ce courant de compensation est mesuré à l'extrémité 9 de l'enroulement 6 par la chute de tension sur une résistance de mesure 10, une image du courant primaire apparaissant ainsi à la borne 11.

Selon la présente invention, l'enroulement secondaire 6 est entouré sur sa surface extérieure par au moins une couche de spires, de préférence jointives, qui forment un enroulement de protection 12 destiné à constituer un écran électrique notamment vis-à-vis du conducteur 4. A cet effet, l'enroulement 12 est ouvert et est connecté dans son ensemble à un potentiel électrique fixe tel que celui de la masse 13.

L'enroulement 12, réalisé par exemple en fil émaillé assurant son isolation et pouvant être le même fil que celui de l'enroulement secondaire 6, recouvre l'ensemble de cet enroulement 6, de sorte que pratiquement aucun courant parasite n'est engendré dans la bobine secondaire sous l'effet des variations de potentiel du conducteur primaire.

L'agencement selon l'invention crée ainsi un écran parfait et présente en outre l'avantage d'une solution très économique, l'enroulement de protection pouvant être réalisé d'une manière analogue à celle de l'enroulement secondaire.

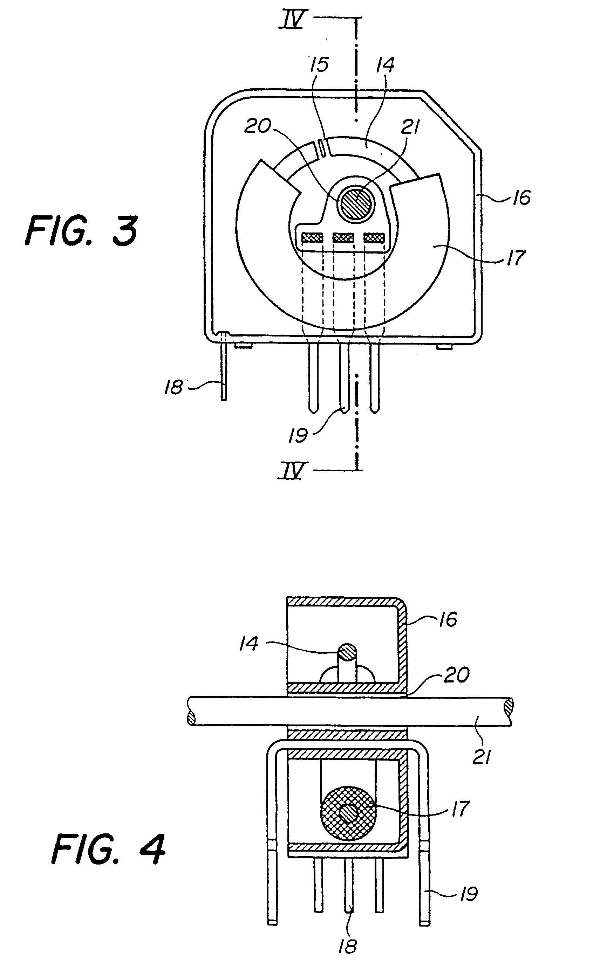

Les Figures 3 et 4 montrent une forme d'exécution d'un capteur permettant notamment la mesure différentielle de deux courants de sens opposé parcourant des conducteurs primaires à haute isolation l'un par rapport à l'autre.

Un circuit magnétique sous forme d'un tore 14 présentant un entrefer 15 est disposé dans un boîtier 16 du capteur. Ce circuit magnétique porte une bobine secondaire 17 comportant au moins un enroulement secondaire relié à des broches, telles que 18, destinées à être connectées à un circuit extérieur, par exemple sur une plaque de circuit imprimée (non-représentée). Les broches 18 peuvent également servir à la connexion d'une cellule de Hall disposée dans l'entrefer 15 et d'un enroulement de protection, tel que décrit ci-dessus.

Selon les Figures 3 et 4, le capteur comporte trois parties de conducteur en forme de U, telles que 19, passant à l'intérieur du circuit magnétique 14. Ces parties de conducteur peuvent être connectées à un conducteur primaire soit individuellement, soit en parallèle, soit en série, soit encore en série-parallèle. Ce conducteur peut ainsi être couplé avec le circuit magnétique en formant deux spires autour du tore 14 muni de la bobine secondaire 17.

Par ailleurs, le boîtier 16 comporte une ouverture 20 dans laquelle passe un conducteur primaire 21 en traversant le circuit magnétique 14. Ce conducteur 21 peut être muni d'une isolation qui lui est propre, de façon à assurer une tenue en tension élevée par rapport aux trois parties de conducteur primaire 19.

L'agencement selon les Figures 3 et 4 permet ainsi d'utiliser un tel capteur soit pour la mesure d'un courant primaire passant dans le conducteur 21 ou dans une ou plusieurs des parties de conducteur 19, soit pour la mesure différentielle des courants passant, respectivement, dans le conducteur 21 et dans une ou plusieurs des parties 19. Les extrémités de ces parties 19 servent à connecter électriquement ces parties au conducteur primaire correspondant ainsi qu'à supporter le capteur sur une plaque de circuit extérieure.

## Revendications

1. Capteur de courant électrique pour la mesure du courant passant dans un conducteur primaire, comportant un circuit magnétique (1) couplé avec une bobine secondaire (6) et agencé de façon à pouvoir être couplé avec ledit conducteur primaire (4), des moyens (3) pour mesurer le flux magnétique dans ce circuit magnétique, des moyens d'asservissement (8) agencés de façon à faire passer, dans la bobine secondaire, un courant de compensation tendant à annuler ledit flux magnétique, des moyens de mesure (10, 11) de ce courant de compensation, et une ouverture de passage traversant l'intérieur du circuit magnétique de façon à permettre l'insertion d'au moins un premier conducteur primaire (4), **caractérisé en ce que** deux ou plusieurs parties séparées (19) de conducteur primaire entourent partiellement des sections respectives du circuit magnétique; ces parties de conducteur étant agencées de façon à pouvoir être connectées, à l'extérieur du capteur, individuellement, en série, en parallèle ou en série-parallèle à au moins un deuxième conducteur primaire.

2. Capteur de courant selon la revendication 1, **caractérisé en ce que** lesdites parties séparées (19) de conducteur primaire sont des parties en forme de U, dont les extrémités sont agencées de façon à permettre le montage de ces parties sur une plaque de circuit extérieure au capteur pour leur connexion électrique et/ou le support du capteur.

3. Capteur de courant électrique selon l'une des revendication précédentes, **caractérisé en ce que** la bobine secondaire (5) comporte, à la surface d'un enroulement (6) parcouru par le courant de compensation, au moins une couche de spires en fil isolé formant un enroulement de protection (12) ouvert, connecté dans son ensemble à un point de potentiel électrique fixe (13).

4. Capteur de courant selon la revendication 3, **caractérisé en ce que** les spires de l'enroulement de protection (12) sont jointives.

5. Utilisation du capteur selon l'une des revendications précédentes pour la mesure différentielle de deux courants primaires de sens opposé, passant, respectivement, dans un conducteur traversant ladite ouverture et dans au moins une desdites parties séparées de conducteur primaire.

## Patentansprüche

1. Elektrischer Strommessfühler zur Messung des durch einen Primärleiter fliessenden Stromes, mit einem magnetischen Kreis (1), der an eine Sekundärspule (6) angekoppelt und so eingerichtet ist, dass er mit dem benannten Primärleiter (4) gekoppelt werden kann, mit Organen (3) zur Messung des magnetischen Kraftflusses in diesem magnetischen Kreis, mit Steuerorganen (8), die so eingerichtet sind, dass sie in der Sekundärspule einen Kompensationsstrom fliessen lassen, der den benannten magnetischen Kraftfluss aufzuheben sucht, mit Organen zur Messung (10, 11) dieses Kompensationsstromes und mit einer Durchlassöffnung, die das Innere des magnetischen Kreises so quert, dass zumindest ein Primärleiter (4) eingeführt werden kann, **dadurch gekennzeichnet, dass** zwei oder mehrere getrennte Primärleiterabschnitte (19) entsprechende Segmente des magnetischen Kreises teilweise umschliessen, wobei diese Leiterabschnitte so eingerichtet sind, dass sie ausserhalb des Messfühlers individuell, in Reihe, in parallel oder in Reihenparallelschaltung an zumindest einen zweiten Primärleiter angeschlossen werden können.

2. Strommessfühler gemäss Anspruch 1, **dadurch gekennzeichnet, dass** die benannten getrennten Primärleiterabschnitte (19) U-förmige Abschnitte sind, deren Enden so eingerichtet sind, dass diese Abschnitte für ihre elektrische Verbindung und/oder zum Halten des Messfühlers auf eine Leiterplatte ausserhalb des Messfühlers montiert werden können.

3. Elektrischer Strommessfühler gemäss einem der vorangehenden Ansprüche, **dadurch gekennzeichnet, dass** die Sekundärspule (5) auf der Oberfläche einer vom Kompensationsstrom durchflossenen Wicklung (6) zumindest eine Schicht von Windungen aus isoliertem Draht umfasst, die eine offene Schutzwicklung (12) bilden, die als Ganzes an einen Punkt mit festem elektrischem Potenzial (13) gelegt ist.

4. Strommessfühler gemäss Anspruch 3, **dadurch gekennzeichnet, dass** die Windungen der Schutzwicklung (12) englagig sind.

5. Verwendung des Messfühlers gemäss einem der vorangehenden Ansprüche zur differentiellen Messung von zwei entgegengesetzten Primärströmen, die in einem durch die benannte Öffnung führenden Leiter und in zumindest einem der benannten getrennten Primärleiterabschnitte fliessen.

## Claims

1. Electrical current sensor for measuring current flowing through a primary conductor, comprising a magnetic circuit (1) coupled to a secondary coil (5) and arranged so that it may be coupled with said primary conductor (4), means (3) for measuring the magnetic flux in the magnetic circuit, control means (8) arranged to produce, in the secondary coil, a compensation current seeking to eliminate said magnetic flux, means (10, 11) for measuring said compensation current and an opening traversing the interior of the magnetic circuit so as to enable insertion of at least a first primary conductor (4), **characterized in that** two or more separate primary conductor portions partially surround respective sections of the magnetic circuit, said conductor portions (19) being arranged so that they may be connected externally of the sensor, individually, in series, in parallel or in series-parallel to at least a second primary conductor.

2. Current sensor according to claim 1, **characterized in that** said separate primary conductor portions (19) are portions in the form of a U whose extremities are arranged so as to enable assembly of these portions on a circuit board external to the sensor for their electrical connection and/or for supporting the sensor.

3. Current sensor according to any preceding claim, **characterized in that** the secondary coil (5) comprises, at the surface of winding (6) through which the compensation current flows, at least one layer of spires made of insulated wire forming an open protective winding (12), connected as a whole to a point of fixed electrical potential (13).

4. Current sensor according to claim 3, **characterized in that** the spires of the protective winding (12) are interconnected.

5. Use of a sensor according to any preceding claim for the differential measure of two primary currents of opposite direction, flowing respectively through a conductor traversing said opening and through at least one of said separate primary conductor portions.
